# EUROPEAN PATENT APPLICATION

(11) **EP 4 203 461 A1**
(43) Date of publication of application: **28.06.2023**
(21) Application number: 21216883.5
(22) Date of filing: 22.12.2021
(51) Int. Cl.: H04N 5/369, H04N 5/374, H01L 27/146

(54) **A PHOTO-SENSITIVE DEVICE, AN IMAGE SENSOR, AND A METHOD FOR LIGHT DETECTION IN A PHOTO-SENSITIVE DEVICE**

(71) Applicant: Imec VZW, 3001 Leuven (BE)
(72) Inventor: Lee, Jiwon, 3020 Herent (BE); Malinowski, Pawel, 3001 Heverlee (BE); Li, Yunlong, 3001 Heverlee (BE); Georgitzikis, Epimitheas, 1060 Saint-Gilles (BE)
(74) Representative: AWA Sweden AB

(57) **Abstract**

A method for light detection in a photo-sensitive device (100; 400; 500) comprising a stack (102; 402; 502) forming a photodiode, said method comprising: controlling (604) a voltage bias of the photodiode by setting a potential of a bias electrode (110; 410; 510) separated by a dielectric material (112) from the stack (102; 402; 502) at a first lateral part (122; 422; 522) of the photo-sensitive device (100; 400; 500), wherein the potential of the bias electrode (110; 410; 510) is fixed during an integration time for controlling light sensitivity; generating (606) charges and accumulating (608) charges during the integration time at the first charge transport layer (114; 414; 514) of the stack (102; 402; 502) in a second lateral part (124; 424; 524) of the photo-sensitive device (100; 400; 500) being connected to a read-out circuit (130) for reading out a signal representative of the incident light.

## Description

### Technical field

The present inventive concept relates to a method for light detection in a photo-sensitive device. The present inventive concept further relates to a photo-sensitive device and an image sensor. In particular, the present inventive concept relates to photo-sensitive devices and method for light detection in photo-sensitive devices that may be formed by thin-film technology.

### Background

Using silicon in light detection sets limits to the wavelengths that may be detected, based on optical characteristics of silicon. Therefore, it is of interest to use other materials in light detection. In this regard, photo-sensitive devices that may be formed using thin-film technology are interesting, since such photo-sensitive devices could be monolithically integrated on semiconductor substrates to still make use of the semiconductor substrate to provide circuitry for read-out and processing of signals from the photo-sensitive devices. This would facilitate e.g., infra-red imaging.

A photodiode formed using thin-film technology may be connected to a floating diffusion node in a read-out circuitry on a semiconductor substrate. When light is incident on the photodiode, charges may be generated through absorption of light and generated charges may be integrated in the floating diffusion node. However, this leads to a changing voltage at the floating diffusion node during integration time, which also leads to a change in photodiode bias during integration time. Hence, sensitivity of the photodiode to incident light may change during integration such that output from the photodiode becomes non-linear.

### Summary

An objective of the present inventive concept is to provide a photo-sensitive device and a method for light detection in a photo-sensitive device which provides high light sensitivity which is maintained during integration time.

These and other objectives of the present inventive concept are at least partly met by the invention as defined in the independent claims. Preferred embodiments are set out in the dependent claims.

According to a first aspect, there is provided a method for light detection in a photo-sensitive device, wherein the photo-sensitive device comprises a stack forming a photodiode, which stack comprises a first charge transport layer, a photon-absorbing layer and a second charge transport layer, wherein the photon-absorbing layer is arranged between the first charge transport layer and the second charge transport layer, and wherein the first charge transport layer and the second charge transport layer are configured to transport charges of opposite signs, wherein the photo-sensitive device comprises a first lateral part and a second lateral part different from the first lateral part, wherein the photo-sensitive device in the first lateral part comprises at least the photon-absorbing layer and the second charge transport layer of the stack and wherein the photo-sensitive device in the second lateral part comprises at least the first charge transport layer of the stack, said method comprising: controlling a voltage bias of the photodiode by setting a potential of a bias electrode associated with and separated by a dielectric material from the stack at the first lateral part of the photo-sensitive device, wherein the potential of the bias electrode is fixed during an integration time for controlling light sensitivity of the photodiode; generating charges during the integration time in the photon-absorbing layer in response to incident light on the photo-sensitive device; and accumulating charges during the integration time at the first charge transport layer in the second lateral part of the photo-sensitive device, wherein the first charge transport layer in the second lateral part of the photo-sensitive device is connected to a read-out circuit for reading out a signal representative of the incident light during the integration time on the photo-sensitive device.

Thanks to the method, voltage bias of the photodiode is controlled at a first lateral part of the photo-sensitive device, whereas the charges are accumulated at the first charge transport layer in the second lateral part of the photo-sensitive device. This implies that voltage bias of the photodiode is provided physically separate from the accumulation of charges. Hence, a fixed potential of the bias electrode may act for maintaining a constant bias of the photodiode in the first lateral part of the photo-sensitive device, such that light sensitivity is not affected during the integration time.

The charges generated in the photon-absorbing layer may flow towards the second lateral part of the photo-sensitive device to be accumulated at the first charge transport layer in the second lateral part of the photo-sensitive device. While the charges are accumulated in the second lateral part of the photo-sensitive device, the voltage bias of the photodiode may be controlled by the fixed potential of the bias electrode.

The method allows controlling the voltage bias of the photodiode without a need for handling a variation in voltage for biasing of the photodiode. This implies that the voltage bias may be controlled at a voltage level corresponding to high sensitivity of the photodiode while having a low dark current. In contrast, if the bias of the photodiode would change during integration, the photodiode may need to be initially biased at an unnecessarily high voltage such that the photodiode would have a high dark current.

It should be realized that it is desired that the potential of a node which is to be used for reading out a signal representative of incident light should vary during the integration time. Since a signal representative of incident light is to be read out, the signal needs to be dependent of an amount of incident light. Hence, the potential of the first charge transport layer in the second lateral part of the photo-sensitive device should inevitably be varying during the integration time.

According to the present inventive concept, the voltage bias of the photodiode is controlled separately from the node which is to be used for reading out the signal representative of incident light. Hence, the voltage bias of the photodiode may be controlled by setting the potential of the bias electrode to a constant level during the integration time, such that variations in light sensitivity of the photodiode during integration time may be avoided or at least reduced.

The photodiode is configured to generate an electron-hole pair by absorption of photons of sufficient energy. Further, an electric field is provided across the photodiode such that generated holes move towards a negative node at one side of the photodiode and electrons move towards a positive node at another side of the photodiode. The negative node and the positive node may be arranged at opposite sides of the photon-absorbing layer.

The photon-absorbing layer of the stack may comprise a material which is configured to absorb photons of a sufficient energy corresponding to a wavelength of interest, e.g., infrared wavelengths. The stack may be configured to drive holes and electrons towards charge transport layers on opposite sides of the photon-absorbing layer, respectively, with the photon-absorbing layer being sandwiched between the first charge transport layer and the second charge transport layer. In this regard, the stack may in a lateral part comprise each of the first charge transport layer, the photon-absorbing layer and the second charge transport layer. However, it should be realized that the layers may be diagonally arranged in the stack such that the first charge transport layer is not necessarily overlapping the second charge transport layer.

The charge transport layers of the stack may comprise a material which is configured to allow a flow of charges of a particular sign within the charge transport layer along a direction of largest extension of the charge transport layer. The charge transport layers are configured to transport charges of opposite signs such that one of the first charge transport layer and the second charge transport layer is an electron transport layer and the other of the first charge transport layer and the second charge transport layer is a hole transport layer.

The stack may be formed by layers arranged on top of each other. Each layer may have a shape like a sheet with a large extension in two dimensions and a much smaller extension transverse to the sheet. The layer may be planar with a large extension in two dimensions in a plane compared to a cross-sectional height perpendicular to the plane. However, it should be realized that the layer need not necessarily be completely planar. Rather, the layer may be at least partly bent or curved, while the layer is still arranged in an overall plane with large extension in two dimensions and a small extension in a perpendicular direction to the other two dimensions. The thickness of a layer (i.e., extension transverse to the sheet) may be constant or may be varying over the sheet formed by the layer.

The layers may be stacked such that the small extensions of the layers are arranged on top of each other, whereby the layers are formed in parallel planes arranged on top of each other.

However, the layers need not have identical extensions in the planes arranged on top of each other. Thus, a cross-section of the photo-sensitive device may in some parts comprise all layers of the stack, whereas a cross-section of the stack may in other parts comprise only one or some layers of the stack.

As used herein, a horizontal direction of the stack or horizontally in the stack is used to describe a direction parallel to the planes of the stack, whereas a vertical direction of the stack or vertically in the stack is used to describe a direction perpendicular to the planes of the stack.

The layers of the stack may be formed by thin-film layer deposition. Thin-film layer deposition may be suitable for monolithic integration of structures using vast amount of materials, e.g., organic materials. This may be advantageously used in the photo-sensitive device, which may be suited for use of e.g., organic materials in light detection.

The stack may comprise further layers in addition to the first charge transport layer, the photon-absorbing layer and the second charge transport layer. Such further layers may have the same or a different extension to the first charge transport layer, the photon-absorbing layer and the second charge transport layers. The further layers may be arranged in-between two layers of the first charge transport layer, the photon-absorbing layer and the second charge transport layers.

For instance, the stack may comprise two or more charge transport layers for transport of charges of one or more signs. Hence, the stack may comprise two different materials for hole transport forming two charge transport layers and/or two different materials for electron transport forming two charge transport layers. At the second lateral part of the photo-sensitive device, there may be a single material used for the first charge transport layer.

The first lateral part of the photo-sensitive device and the second lateral part of the photo-sensitive device are displaced in relation to each other in a direction along the planes of the layers of the stack.

The layers of the stack may have different extensions in the lateral direction. Thus, the photo-sensitive device may comprise different sets of layers in different lateral parts. However, according to an embodiment, the first charge transport layer, the photon-absorbing layer and the second charge transport layer may have a common extension. Hence, the photo-sensitive device may comprise the first charge transport layer, the photon-absorbing layer and the second charge transport layer in the first lateral part and the first charge transport layer, the photon-absorbing layer and the second charge transport layer in the second lateral part.

According to another embodiment, the first charge transport layer may have a larger extension than the photon-absorbing layer and the second charge transport layer. The second charge transport layer and the photon-absorbing layer need not be arranged at the second lateral part of the photo-sensitive device. Thus, the photo-sensitive device may comprise the first charge transport layer, the photon-absorbing layer and the second charge transport layer in the first lateral part and only comprise the second charge transport layer of the stack in the second lateral part.

According to yet another embodiment, the first charge transport layer need not be arranged at the first lateral part of the photo-sensitive device. Thus, the photo-sensitive device may comprise the second charge transport layer and the photon-absorbing layer at the first lateral part and may comprise the first charge transport layer, the photon-absorbing layer and the second charge transport layer at the second lateral part.

The voltage bias of the photodiode may be defined by a relation of electrical potentials at the first charge transport layer, the photon-absorbing layer and the second charge transport layer. The voltage bias is controlled by setting the potential of the bias electrode, which may affect the electrical potential of the first charge transport layer, if present, and the photon-absorbing layer in the first lateral part of the photo-sensitive device. The potential of the bias electrode may be set in relation to a potential of the first charge transport layer at the second lateral part of the photo-sensitive device and to a potential of the second charge transport layer.

The potential of the bias electrode may be fixed during the integration time. Hence, a control signal to the bias electrode may provide a constant potential, such that the potential of the bias electrode is held at a stable and constant level at least during the integration time.

The bias electrode may have an extension corresponding to the first lateral part of the photo-sensitive device. Hence, the photo-sensitive device does not comprise the bias electrode at the second lateral part of the photo-sensitive device.

The bias electrode and the first charge transport layer may be arranged at a common side in relation to the photon-absorbing layer. The bias electrode may have an extension in a direction along the planes of the layers of the stack so as to be arranged in parallel with the stack in a different plane to the planes of the layers of the stack.

The bias electrode may be separated from the stack by a dielectric material. This implies that a potential of the bias electrode affects potential of the layers of the stack, but charges are not allowed to flow from the stack to the bias electrode.

The integration time is a time during which charges are generated and accumulated. The charges may be continuously generated in the photon-absorbing layer and continuously accumulated at the first charge transport layer in the second lateral part of the photo-sensitive device during the integration time. The integration time may be defined as a time between a reset of a voltage at a node connected to the first charge transport layer at the second lateral part and a readout of the voltage at the node. Thus, an amount of charges accumulated during the integration time may be converted to a signal which is representative of light incident on the photo-sensitive device.

The photo-sensitive device may be configured to continuously generate and accumulate charges, whereas reset and readout may be used for enabling relating the signal being read out to a light intensity. However, it should be realized that the photo-sensitive device may further be arranged in relation to a shutter, which may control whether or not light is allowed to reach the photo-sensitive device.

The first charge transport layer in the second lateral part of the photo-sensitive device being connected to a read-out circuit implies that an electrical and physical connection to the read-out circuit is provided at the second lateral part of the photo-sensitive device. For instance, a metal wire physically connected to the read-out circuit may be physically connected to the first charge transport layer in the second lateral part of the photo-sensitive device.

According to an embodiment, the potential of the bias electrode is set in relation to potential of the first charge transport layer at the second lateral part of the photo-sensitive device such that charges to be accumulated in the first charge transport layer at the second lateral part of the photo-sensitive device are transported towards the first charge transport layer at the second lateral part of the photo-sensitive device during the integration time.

The potential of the first charge transport layer at the second lateral part may vary during the integration time due to the accumulation of charges therein. The potential of the bias electrode may be selected to be set such that charges will flow towards the first charge transport layer at the second lateral part throughout the integration time.

It should be realized that charges may be transported within the photon-absorbing layer towards the first charge transport layer at the second lateral part of the photo-sensitive device. However, it should be realized that charges may be configured to be transported vertically in the stack towards the first charge transport layer and may thereafter be transported horizontally within the first charge transport layer towards a position of the first charge transport layer at the second lateral part.

A conductivity of the first charge transport layer may be higher than a conductivity of the photon-absorbing layer. Hence, the first charge transport layer may preferably have an extension between the first lateral part and the second lateral part, such that charges may be mainly transported horizontally in the stack through the first charge transport layer. However, the first charge transport layer need not necessarily be arranged in the first lateral part of the photo-sensitive device. In fact, if the photon-absorbing layer has a high conductivity, the photo-sensitive device need not necessarily include a second transport layer in the first lateral part of the photo-sensitive device. Thus, it should be understood that the photo-sensitive device in the first lateral part may comprise the photon-absorbing layer of the stack and need not comprise the second charge transport layer.

According to an embodiment, wherein the first lateral part of the photo-sensitive device defines a first area corresponding to a projection of the stack onto the bias electrode and wherein the second lateral part of the photo-sensitive device defines a second area corresponding to a cross-section of an interconnect between the first charge transport layer and the read-out circuit, wherein the first area is larger than the second area.

The photon-absorbing layer may be arranged to extend to the second lateral part of the photo-sensitive device. Hence, generation of charges may take place both in the first lateral part of the photo-sensitive device and in the second lateral part of the photo-sensitive device.

The potential at the second area may at least partly affect a potential of the photon-absorbing layer, in particular a potential of the photon-absorbing layer at the second lateral part of the photo-sensitive device, such that light sensitivity of the photodiode may be partly affected. Thanks to the first area being larger than the second area, an effect of the potential at the second area is small in comparison to the voltage bias controlled by setting the potential of the bias electrode.

The second area may be configured to be as small as possible, such as a size of the second area being determined by a capability of a manufacturing process. Thus, the first area may be much larger than the second area. However, it should be realized that the first area may also be relatively small in order to enable a high resolution of an array of photo-sensitive device. According to an embodiment, the first area may be at least two or at least ten times larger than the second area.

According to an embodiment, the first charge transport layer is separated from the photon-absorbing layer at the second lateral part of the photo-sensitive device.

This implies that an effect of the potential at the first charge transport layer in the second lateral part on the potential of the photon-absorbing layer may be diminished, such that variations in light sensitivity of the photodiode during integration time may be further avoided or at least reduced.

The first charge transport layer may be separated from the photon-absorbing layer at the second lateral part of the photo-sensitive device by the photon-absorbing layer not extending to the second lateral part of the photo-sensitive device.

Alternatively, the first charge transport layer may be separated from the photon-absorbing layer at the second lateral part of the photo-sensitive device by a dielectric material being provided between the first charge transport layer and the photon-absorbing layer at the second lateral part of the photo-sensitive device.

According to an embodiment, the photo-sensitive device further comprises a top electrode arranged at an opposite side of the stack in relation to the bias electrode, wherein the method further comprises setting a potential of the top electrode in relation to the potential of the bias electrode such that charges to be accumulated in the first charge transport layer at the second lateral part of the photo-sensitive device are transported in the photon-absorbing layer towards the first charge transport layer during the integration time.

Thanks to setting a potential of the top electrode and setting a potential of the bias electrode, a potential across the photodiode may be well-defined. Hence, the setting of the potential of the top electrode may contribute to controlling the voltage bias of the photodiode.

Further, the setting of the potential of the top electrode may be used for controlling charges of a first sign to be transported towards the first charge transport layer and controlling charges of a second sign, opposite to the first sign, to be transported towards the second charge transport layer.

It should be realized that the term "top electrode" does not necessarily mean that the top electrode is arranged above the stack. Rather, the top electrode and the bias electrode are arranged at opposite sides of the stack in a vertical direction of the stack.

According to an embodiment, the first charge transport layer at the second lateral part of the photo-sensitive device defines a floating diffusion node, the method further comprising, at end of the integration time, selectively reading out a voltage signal at the floating diffusion node using the read-out circuit.

A potential of the floating diffusion node may be determined by an amount of accumulated charges stored in the floating diffusion node. The method comprises reading out the voltage signal at the floating diffusion node at the end of the integration time such that a signal corresponding to the amount of charges accumulated at the floating diffusion node may be read out.

The reading out of the voltage signal at the floating diffusion node may be controlled by a select signal. The select signal may control a point in time at which the voltage signal at the floating diffusion node is read out. This may be used e.g., for controlling an order in which signals from different photo-sensitive devices in an array are read out on a read-out line shared by the photo-sensitive devices.

According to an embodiment, the method further comprises, prior to the integration time, resetting a voltage at the floating diffusion node using the read-out circuit.

Thus, the voltage at the floating diffusion node may be reset before charges are accumulated at the floating diffusion node. Hence, by resetting the voltage at the floating diffusion node, a plurality of measurements, sequential in time, may be acquired of light intensity incident on the photo-sensitive device. Even if a single measurement of light intensity is made, the resetting of the voltage at the floating diffusion node may provide an accurate definition of the start of the integration time.

According to a second aspect, there is provided a photo-sensitive device comprising: a stack forming a photodiode, which stack comprises a first charge transport layer, a photon-absorbing layer and a second charge transport layer, wherein the photon-absorbing layer is arranged between the first charge transport layer and the second charge transport layer, and wherein the first charge transport layer and the second charge transport layer are configured to transport charges of opposite signs, and wherein the photon-absorbing layer is configured to generate charges in response to incident light on the photo-sensitive device, wherein the photo-sensitive device comprises a first lateral part and a second lateral part different from the first lateral part, wherein the photo-sensitive device in the first lateral part comprises at least the photon-absorbing layer and the second charge transport layer of the stack and wherein the photo-sensitive device in the second lateral part comprises at least the first charge transport layer of the stack; a bias electrode associated with and separated by a dielectric material from the stack at the first lateral part of the photo-sensitive device, wherein the photo-sensitive device is configured to set a fixed potential of the bias electrode during an integration time for controlling light sensitivity of the photodiode; wherein the photo-sensitive device is configured to accumulate charges at the first charge transport layer in the second lateral part of the photo-sensitive device during the integration time, and wherein the first charge transport layer in the second lateral part of the photo-sensitive device is connected to a read-out circuit for reading out a signal representative of the incident light during the integration time on the photo-sensitive device.

Effects and features of this second aspect are largely analogous to those described above in connection with the first aspect. Embodiments mentioned in relation to the first aspect are largely compatible with the second aspect.

The bias electrode is configured to control a voltage bias of the photodiode at a first lateral part of the photo-sensitive device, whereas the photo-sensitive device is configured to accumulated charges at the first charge transport layer in the second lateral part of the photo-sensitive device. This implies that voltage bias of the photodiode is provided physically separate from the accumulation of charges. Hence, a fixed potential of the bias electrode may act for maintaining a constant bias of the photodiode in the first lateral part of the photo-sensitive device, such that light sensitivity is not affected during the integration time.

According to an embodiment, the first charge transport layer is patterned such that the first charge transport layer is absent at the first lateral part of the photo-sensitive device.

This implies that the first charge transport layer is not arranged between the bias electrode and the photon-absorbing layer. Hence, the bias electrode may provide an improved control of the potential in the photon-absorbing layer for controlling a voltage bias of the photodiode.

According to an alternative embodiment, the first charge transport layer extends continuously between the first lateral part and the second lateral part of the photo-sensitive device.

This may promote transport of charges towards the first charge transport layer at the second lateral part. The transport may take place mainly in a horizontal direction in the first charge transport layer, which may have a larger conductivity than the photon-absorbing layer.

According to an embodiment, the first charge transport layer is separated from the photon-absorbing layer at the second lateral part of the photo-sensitive device.

This implies that an effect of the potential at the first charge transport layer in the second lateral part on the potential of the photon-absorbing layer may be diminished, such that variations in light sensitivity of the photodiode during integration time may be further avoided or at least reduced.

The first charge transport layer may be separated from the photon-absorbing layer at the second lateral part of the photo-sensitive device by the photon-absorbing layer not extending to the second lateral part of the photo-sensitive device.

Alternatively, the first charge transport layer may be separated from the photon-absorbing layer at the second lateral part of the photo-sensitive device by a dielectric material being provided between the first charge transport layer and the photon-absorbing layer at the second lateral part of the photo-sensitive device.

According to an embodiment, wherein the first charge transport layer is an electron transport layer, and the second charge transport layer is a hole transport layer.

Suitable materials for electron transport layer may be available for providing high conductivity of electrons such that an efficient transport of charges to be accumulated at the electron transport layer in the second lateral part of the photo-sensitive device may be achieved.

However, it should be realized that the first charge transport layer may instead be a hole transport layer and the second charge transport layer may be an electron transport layer.

According to an embodiment, the first lateral part of the photo-sensitive device defines a first area corresponding to a projection of the stack onto the bias electrode and wherein the second lateral part of the photo-sensitive device defines a second area corresponding to a cross-section of an interconnect between the first charge transport layer and the read-out circuit, wherein the first area is larger than the second area.

Thanks to the first area being larger than the second area, an effect of the potential at the second area on light sensitivity of the photodiode is small in comparison to the voltage bias controlled by setting the potential of the bias electrode.

According to a third aspect, there is provided an image sensor comprising an array of photo-sensitive devices according to the second aspect.

Thus, the photo-sensitive devices may be used for forming an imaging sensor to enable imaging. For instance, this may be very useful for infrared imaging, since the photon-absorbing layer of the photo-sensitive devices according to the second aspect may be formed from other materials than silicon and may thus provide sensitivity to infrared light.

According to an embodiment, the second charge transport layer and the photon-absorbing layer are continuous layers extending over a plurality of photo-sensitive devices of the array.

The second charge transport layer and the photon-absorbing layer may be formed from materials which may be difficult to pattern. Hence, for ease of manufacturing, it may be advantageous that the second charge transport layer and the photo-absorbing layer are continuous layers extending over a plurality of photo-sensitive devices.

In other embodiments, only one of the second charge transport layer and the photon-absorbing layer is a continuous layer.

According to another embodiment, the second charge transport layer and the photon-absorbing layer are patterned such that the second charge transport layer of a first photo-sensitive device is physically separate from the second charge transport layer of a second photo-sensitive device, neighboring to the first photo-sensitive device and that the photon-absorbing layer of the first photo-sensitive device is physically separate from the photon-absorbing layer of the second photo-sensitive device.

This may be advantageous in avoiding cross-talk between neighboring photo-sensitive devices.

According to an embodiment, the first charge transport layer, the photon-absorbing layer and the second charge transport layer of the photo-sensitive devices are arranged on a semiconductor substrate comprising the read-out circuit for reading out the signals representative of the incident light on the photo-sensitive device.

This implies that the photo-sensitive device may be integrated with a substrate on which the read-out integrated circuit is provided. This ensures that the image sensor with read-out circuitry may be very compact and allows processing of detected signals in a small-scale device. The read-out integrated circuit may be used for reading out signals of detected amount of light but may also be used for more advanced processing of the signals.

The read-out integrated circuit may be formed by semiconductor technology, such as using complementary metal-oxide-semiconductor (CMOS) circuitry. Thus, the image sensor may make use of existing technology for manufacturing of small-scale circuitry.

However, according to an alternative, the read-out integrated circuit may be designed by using thin-film technology.

### Brief description of the drawings

The above, as well as additional objects, features, and advantages of the present inventive concept, will be better understood through the following illustrative and non-limiting detailed description, with reference to the appended drawings. In the drawings like reference numerals will be used for like elements unless stated otherwise.
Fig. 1a is a schematic view of a photo-sensitive device providing background to the present inventive concept.
Fig. 1b is an illustration of a circuitry for reading out a signal from a photodiode.
Fig. 2 is a schematic view of a cross-section of a photo-sensitive device according to a first embodiment.
Fig. 3 is a schematic view of an image sensor according to an embodiment.
Fig. 4 is a schematic view of a cross-section of neighboring photo-sensitive devices of an array.
Fig. 5 is a schematic view of a cross-section of a photo-sensitive device according to a second embodiment.
Fig. 6 is a schematic view of a cross-section of a photo-sensitive device according to a third embodiment.
Fig. 7 is a flow chart of a method according to an embodiment.

### Detailed description

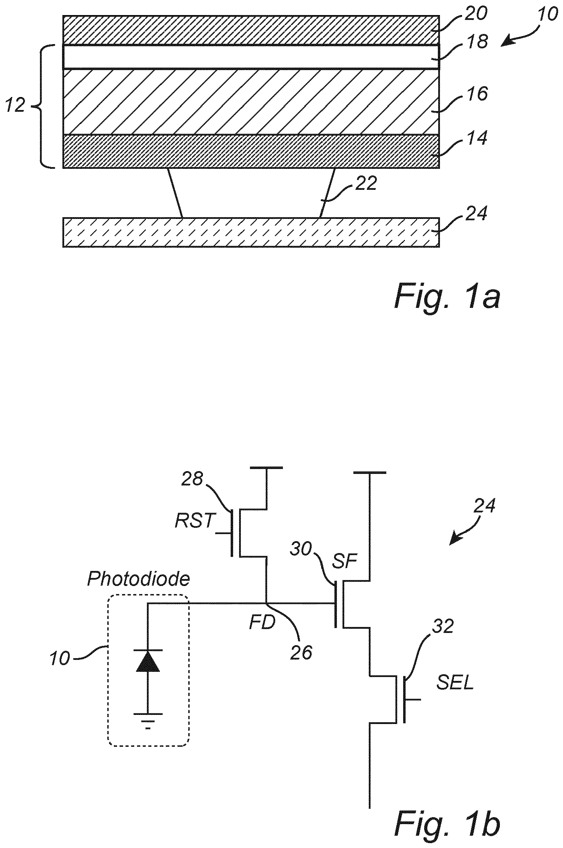

Fig. 1a illustrates a photo-sensitive device 10 providing background to the present inventive concept. The photo-sensitive device 10 may be a photodiode formed by a stack 12 including a photon-absorbing layer 16 sandwiched between a first charge transport layer 14 in form of an electron transport layer (ETL) and a second charge transport layer 18 in form of a hole transport layer (HTL).

The photo-sensitive device 10 further comprises a top electrode 20 and the ETL 14 may be connected via a bottom contact 22 to a floating diffusion node in a read-out circuitry 24. The potentials of the top electrode 20 and the floating diffusion node may together define a voltage bias of the photodiode.

Fig. 1b illustrates an electronic circuit in which the photodiode is connected to read-out circuitry 24 including a floating diffusion node 26, a reset transistor 28, a source follower transistor 30 and a select transistor 32. It should be realized that this is one illustrating example of how the read-out circuitry 24 may be implemented. As understood by the person skilled in the art, the read-out circuitry 24 may be implemented in other manners.

The floating diffusion node 26 may be reset by applying a high voltage to gate of reset transistor 28. Then, the floating diffusion node 26 starts to accumulate charges generated from the photodiode and continues to accumulate charges during an integration time. The floating diffusion node 26 is connected to gate of the source follower transistor 30 and the accumulated charges may be read as a voltage signal via the source follower transistor 30 while the select transistor 32 is turned on by a signal on the gate of the select transistor 32.

Due to the accumulation of charges, the photo-sensitive device 10 needs to have some amount of variation of the voltage of the floating diffusion node 26. As is clear from Fig. 1a, this also implies that a variation in potential of the ETL 14 which is connected to the floating diffusion node 26.

In order to guarantee that the photodiode maintains a reverse bias even if a large amount of charges have been accumulated at the floating diffusion node 26, the photodiode needs to be biased with a sufficiently high reverse voltage. This implies that light sensitivity of the photodiode is relatively constant for different voltages of the floating diffusion node 26, even when the floating diffusion node 26 is almost saturated.

However, this implies that the photodiode is biased with a high voltage, which leads to the photodiode having a high dark current. This implies that the photodiode may have a poor signal-to-noise ratio.

Further, the variation of the voltage of the floating diffusion node 26 also implies that the bias of the photodiode is changed during integration time. Hence, light sensitivity will change during accumulation of charges, such that the photodiode provides a non-linear response to incident light.

According to the present inventive concept, which will now be described, a photo-sensitive device is controlled such that changing of voltage bias of a photodiode is limited during integration time. This implies that the photodiode may have a linear response to incident light over the integration time. Also, the voltage bias may be selected and set at a voltage level corresponding to a low dark current such that a high light sensitivity may be provided with a low dark current. Hence, a good signal-to-noise ratio of the photodiode may be provided.

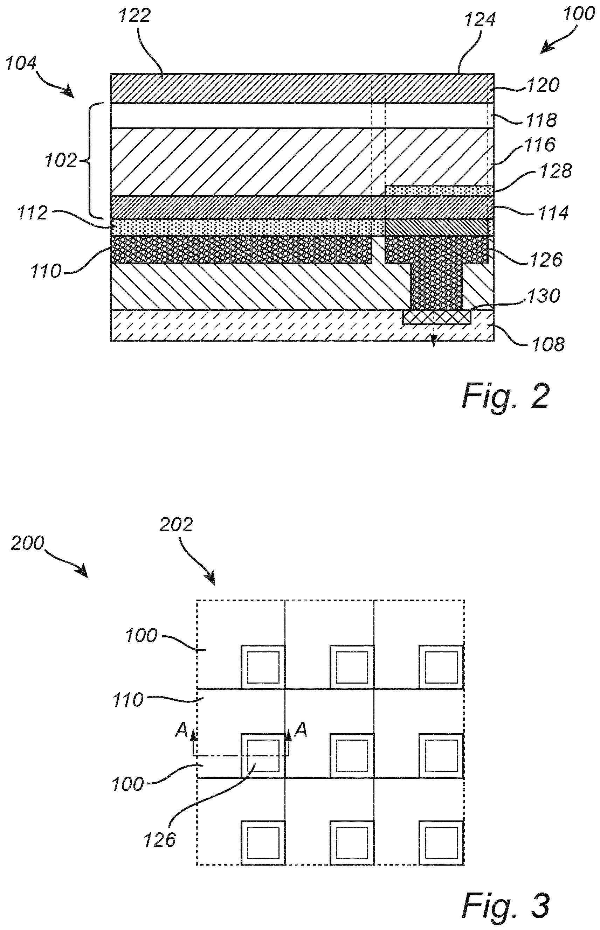

Fig. 2 illustrates a cross-section of a photo-sensitive device 100 taken along lines A-A in Fig. 3. Fig. 3 shows an array of photo-sensitive devices 100, which will be discussed later. However, it should be realized that the below discussion of the photo-sensitive device 100 of Fig. 2 applies to a photo-sensitive device 100 which may be used in isolation and it not necessarily arranged in an array.

The photo-sensitive device 100 comprises a layer structure forming a stack 102 for detecting incident light and converting incident light to a signal corresponding to the amount of incident light.

The stack 102 of the photo-sensitive device 100 may be suitable for being formed by thin-film layer deposition. This may ensure that the photo-sensitive device 100 may be very compact and small-size and may also facilitate use of the photo-sensitive device 100 in combination with a read-out integrated circuit, which may also be formed using thin-film technology or which may be formed by semiconductor processing on a semiconductor substrate. It should however be realized that the stack 102 need not necessarily be formed using thin-film layer deposition.

The photo-sensitive device 100 may comprise a photon-absorbing layer 116, which may be configured to absorb light and generate charges based on the absorbed light. Thus, electron-hole pairs may be generated by the active layer based on light being absorbed. The electron charges and hole charges may be transferred to respective charge transport layers 114, 118 on opposite sides of the photon-absorbing layer 116 such that the photon-absorbing layer 116 may be sandwiched between the charge transport layers 114, 118. Thus, generated electron charges may be transferred to a first charge transport layer forming an electron transport layer 114 and generated hole charges may be transferred to a second charge transport layer forming a hole transport layer 118, such that the stack 102 of photon-absorbing layer 116 and the charge transport layers 114, 116 form a photodiode 104.

The photo-sensitive device 100 may comprise a bias electrode 110 and a top electrode 120 on opposite sides of the stack 102 including the charge transport layers 114, 118 and the photon-absorbing layer 116. The bias electrode 110 and the top electrode 120 may be configured to provide an electric field for driving charges generated in the photon-absorbing layer 116 towards the electron transport layer 114 and hole transport layer 118, respectively.

The bias electrode 110 may be separated by a dielectric material 112 from the stack 102. This implies that the bias electrode 110 may control a potential of the photon-absorbing layer 116 without being in direct electric contact with the stack 102.

Thus, when light is incident on the photon-absorbing layer 116, electron charges will be generated and accumulated in the electron transport layer 114, whereas hole charges may be transported to the hole transport layer 118 and be drained through the top electrode 120. The accumulation of charges in the electron transport layer 114 and the hole transport layer 118 prevents or at least reduces recombination of holes and electrons in the photon-absorbing layer 116 to ensure that a high efficiency in light detection is provided by the photo-sensitive device 100.

The photon-absorbing layer 116 may be sensitive to a range of wavelengths of light. The range of wavelengths may be narrow to allow detection of a specific wavelength, but the range of wavelengths may alternatively be broad such that the photo-sensitive device 100 may be able to generally detect an amount of light over a broad range, such as covering the range of visible light and extending into the range of infrared light. In the latter case, the photo-sensitive device 100 may be combined with a filter such that the filter may select which range of wavelengths that should be detected by the photo-sensitive device 100. Also, having a photon-absorbing active layer 116 which is sensitive to a broad range of wavelengths would allow using the same type of photon-absorbing layer 116 within an array of photo-sensitive devices 100, wherein different photo-sensitive devices 100 in the array may be associated with different filters for providing spectrally resolved imaging. Hence, spectrally resolved imaging would not require using different materials for the photon-absorbing layer 116 in different photo-sensitive devices 100.

In particular, the photon-absorbing layer 116 may be formed from a material which is sensitive to wavelengths in the infrared range. Thus, the photo-sensitive device 100 may be used for infrared detection, which may not be achieved with photo-sensitive devices using silicon for light detection. Thus, the photo-sensitive device 100 may be particularly interesting to use for detection of infrared light. However, it should be understood that the photo-sensitive device 100 may also be well suited for detection of visible light by proper selection of the photon-absorbing layer 116.

A material of the photon-absorbing layer 116 may be selected from various materials. In particular, the photo-sensitive device 100 is well suited for using an organic material in the photon-absorbing layer 116, such as an organic semiconductor material.

The photon-absorbing layer 116 may, for example, comprise a quantum dot, such as a quantum dot based on lead sulfide (PbS), lead selenide (PbSe) indium arsenide (InAs), copper selenide (CuSe), or indium antimonide (InSb) or an organic photodetector material. Such materials may be suitable for use in manufacturing of the photo-sensitive device 100 using thin-film technology. Also, such materials may be used for selecting a sensitivity of wavelengths of light of the photo-sensitive device 100 to enable using the photo-sensitive device 100 in various applications spanning a broad range of wavelengths of light from ultraviolet light to infrared light.

However, it should be understood that the photo-sensitive device 100 is not necessarily limited to use of the particular examples of materials of the photon-absorbing layer 116 provided herein. Rather, other materials may also be available and used with the photo-sensitive device 100.

As mentioned above, the first charge transport layer 114 arranged closest to the bias electrode 110 is an electron transport layer 114. The electron transport layer 114 may for instance be formed by a titanium oxide, zinc oxide, or indium-gallium-zinc oxide (IGZO).

Further, the second charge transport layer 118 arranged closest to the top electrode 120 may be a hole transport layer 118.

However, according to another embodiment, the first charge transport layer 114 arranged closest to the bias electrode 110 may instead be a hole transport layer. The hole transport layer 114 may for instance be formed by poly(3,4-ethylenedioxythiophene) polystyrene sulfonate (PEDOT:PSS), molybdenum oxide, nickel oxide, or poly(4-butylphenyl-diphenylamine) (poly-TPD).

Further, in such embodiment, the charge transport layer 118 arranged above the photon-absorbing layer 116 is an electron transport layer 118.

The light to be detected may be incident on the top electrode 120 arranged above the photon-absorbing layer 116 such that light encounters the top electrode 120 before reaching the photon-absorbing layer 116.

The top electrode 120 may be formed from a material that is transparent to relevant wavelengths (to be detected by the photo-sensitive device 100) to ensure that the light is passed to the photon-absorbing layer 116 for detection with high sensitivity. For instance, the top electrode 120 may be formed by indium tin oxide.

The bias electrode 110 and the top electrode 120 may be configured to control a potential of the charge transport layers 114, 118 and the photo-absorbing layer 116 to control function of the photo-sensitive device 100.

The bias electrode 110 may e.g., be formed by a gate metal or polysilicon. The bias electrode 110 may be separated by a layer of a dielectric material 112, such as silicon dioxide, silicon nitride or a high-κ material such as hafnium oxide or aluminum oxide, from the stack 102. The bias electrode 110 may thus be well suited for being formed by semiconductor processing on a semiconductor substrate. Such semiconductor substrate 108 may be combined with the layers of the stack 102 by forming these layers on top of the semiconductor substrate using thin-film layer deposition.

The photo-sensitive device 100 comprises a first lateral part 122 and a second lateral part 124. The bias electrode 110 is associated with the first lateral part 122. In the second lateral part 124, a physical connection 126 is provided to the first charge transport layer 114, such that the first charge transport layer 114 in the second lateral part 124 of the photo-sensitive device 100 is connected to a read-out circuit 130 such that the photo-sensitive device 100 may be connected to a read-out circuit 130 being arranged as shown in Fig. 1b and described above. The read-out circuit 130 may comprise transistors for reading out a signal from the photo-sensitive device 100. In this regard, the first charge transport layer 114 in the second lateral part 124 may form a floating diffusion node of the read-out circuit 130.

The photo-sensitive device 100 is configured to generate charges by the photon-absorbing layer 116 in response to incident light on the photo-sensitive device 100. The photo-sensitive device 100 is further configured to accumulate the generated charges at the first charge transport layer 114 in the second lateral part 124 of the photo-sensitive device 100 during the integration time.

The bias electrode 110 is associated with the first lateral part 122 of the photo-sensitive device 100. The bias electrode 110 provides a potential for affecting voltage bias of the photodiode 104. The bias electrode 110 may be controlled to set a fixed potential of the bias electrode 110 during the integration time. Hence, the bias electrode 110 is set to a constant potential during the integration time.

The bias electrode 110 will affect voltage bias of the photodiode 104 and controls the voltage bias of the photo-sensitive device 100 in the first lateral part 122. The photo-sensitive device 100 is configured to transport generated charges to the second lateral part 124 such that charges will not accumulate at the first charge transport layer 114 in the first lateral part 122 but will only accumulate at the first charge transport layer 114 in the second lateral part 122. This implies that the accumulation of charges will not significantly affect the voltage bias of the photodiode 104, at least not in the first lateral part 122 of the photo-sensitive device 100.

Hence, the photo-sensitive device 100 enables providing a constant voltage bias of the photodiode 104 during the integration time such that the photodiode 104 may provide a linear response to incident light during integration time. Further, the potentials of the bias electrode 110 and the top electrode 120 may be set such that the voltage bias of the photodiode 104 provides a high light sensitivity with a low dark current.

As shown in Fig. 2, the first charge transport layer 114, the photon-absorbing layer 116 and the second charge transport layer 118 may extend over both the first lateral part 122 and the second lateral part 124 of the photo-sensitive device 100. Hence, the photo-sensitive device 100 may provide light sensitivity over an entire area covered by the first lateral part 122 and the second lateral part 124, which may both contribute to performance of the photodiode 104.

However, as will be explained below, the photo-sensitive device 100 need not comprise all of the first charge transport layer 114, the photon-absorbing layer 116 and the second charge transport layer 118 in both the first lateral part 122 and the second lateral part 124 of the photo-sensitive device 100. Rather, the photo-sensitive device 100 in the first lateral part 122 comprises at least the photon-absorbing layer 116 and the second charge transport layer 118 and the photo-sensitive device 100 in the second lateral part 124 comprises at least the first charge transport layer 114.

The potentials of the bias electrode 110, the top electrode 120 and the first charge transport layer 114 in the second lateral part 124 may be controlled such that charges of one sign (e.g., electrons) are transported to the first charge transport layer 114 in the second lateral part 124 and charges of an opposite sign (e.g., holes) are transported to the second charge transport layer 118. Further, the potentials of the bias electrode 110 and the top electrode 120 are set to provide a desired voltage bias of the photodiode 104.

Thus, the potential of the bias electrode 110 may be set in relation to the potential of the first charge transport layer 114 at the second lateral part 124 such that charges to be accumulated in the first charge transport layer 114 at the second lateral part 124 are transported towards the first charge transport layer 114 at the second lateral part 124 during the integration time.

Further, the potential of the top electrode 120 may be set in relation to the potential of the bias electrode 110 such that charges to be accumulated in the first charge transport layer 114 at the second lateral part 124 are transported in the photon-absorbing layer 116 towards the first charge transport layer 114 during the integration time.

The first charge transport layer 114 in the second lateral part 124 forms a floating diffusion node of the read-out circuitry 130. The potential of the floating diffusion node may be controlled by a reset transistor, which sets the potential of the floating diffusion node prior to the integration time. The potential of the floating diffusion node may thereafter be floating during the integration time and dependent on the accumulation of charges in the first charge transport layer 114 in the second lateral part 124.

Thus, the potential of the first charge transport layer 114 in the second lateral part 124 may be set to an initial value based on the resetting of the floating diffusion node and the potential may then decrease as electron charges are accumulated at the first charge transport layer 114 in the second lateral part 124.

If electrons are to be transported towards the first charge transport layer 114 in the second lateral part 124 during the integration time, the potential of the bias electrode 110 should be smaller than the smallest potential assumed by the first charge transport layer 114 in the second lateral part 124 during the integration time. The potential of the bias electrode 110 may be a negative voltage with the potential of the first charge transport layer 114 in the second lateral part 124 being initially set to ground when resetting.

Further, if electrons are to be transported towards the first charge transport layer 114 in the second lateral part 124 during the integration time, holes are to be transported towards the second charge transport layer 118. Hence, a potential of the top electrode 120 should be set to be even smaller than the potential of the bias electrode 110.

It should be realized that if holes are instead to be transported towards the first charge transport layer 114 in the second lateral part 124, the potentials should set in an opposite relation with the potential at the first charge transport layer 114 in the second lateral part 124 being lower than the potential of the bias electrode 110, and the potential of the bias electrode 110 being lower than the potential of the top electrode 120.

The first lateral part 122 of the photo-sensitive device 100 may be defined as a part of the photo-sensitive device 100 associated with the bias electrode 110. Hence, the first lateral part 122 may constitute a part of the photo-sensitive device 100 corresponding to a projection of layers of the photo-sensitive device 100 along the vertical direction of the stack 102 onto the bias electrode 110.

The second lateral part 124 of the photo-sensitive device 100 may be defined as a part of the photo-sensitive device 100 associated with the physical connection 126 of the first charge transport layer 114 in the second lateral part 124 to the read-out circuit 130. Hence, the second lateral part 122 may constitute a part of the photo-sensitive device 100 corresponding to a projection of layers of the photo-sensitive device 100 along the vertical direction of the stack 102 onto a cross-section of the physical connection 126.

Thus, the first lateral part 122 may be associated with a first area corresponding to the area of the bias electrode 110 and the second lateral part 124 may be associated with a second area corresponding to the area of the cross-section of the physical connection 126.

The first area may be larger than the second area. This implies that a larger portion of the photodiode 104 is defined in the first area than in the second area. This is advantageous since the voltage bias in the first area may be well-controlled through the bias electrode 110. The first area may be significantly larger than the second area, such as five times or ten times larger.

As shown in Fig. 2, the stack 104 may comprise a dielectric material layer 128 between the first charge transport layer 114 and the photon-absorbing layer 116 in the second lateral part 124 of the photo-sensitive device 100. This implies that the first charge transport layer 114 is separated from the photon-absorbing layer 116 at the second lateral part 124 of the photo-sensitive device 100.

Thanks to the dielectric material layer 128, an effect of the potential of the first charge transport layer 114 in the second lateral part 124 on the voltage bias of the photodiode 104 is reduced. Since the potential of the first charge transport layer 114 in the second lateral part 124 may vary due to accumulation of charges, this also implies that variation in light sensitivity of the photo-sensitive device 100 during integration time is reduced.

As mentioned above, the stack 102 may be formed using thin-film layer deposition on top of a semiconductor substrate 108. The read-out circuit 130 may be formed as an integrated circuit which may be formed by semiconductor technology, such as using complementary metal-oxide-semiconductor (CMOS) circuitry. Thus, the photo-sensitive device 100 may make use of existing technology for manufacturing of small-scale circuitry.

The stack 102 may be integrated with a substrate 108 on which readout integrated circuit is provided. This ensures that the photo-sensitive device 100 with read-out circuit 130 may be very compact and allows processing of detected signals in a small-scale device. The read-out integrated circuit may be used for reading out signals of detected amount of light and may also be used for more advanced processing of the signals.

The photo-sensitive device 100 may be integrated on a silicon CMOS wafer, on which a read-out integrated circuit is formed. However, it should be realized that the photo-sensitive device 100 may alternatively be formed on other substrates, such as a thin-film technology wafer, which may, for example, use organic materials and on which the read-out integrated circuit may be formed.

The substrate 108 comprising the read-out circuit 130 may be provided with a top insulating layer and via connections through the top insulating layer for providing contact with the read-out circuit 130 through the insulating layer. Further, a metal layer may be formed on the top insulating layer and the metal layer may then be patterned to form the bias electrode 110 and the physical connection 126. The bias electrode 110 may be connected to the read-out circuit 130 such that a control signal for setting the potential of the bias electrode 110 may be provided through the read-out circuit 130. Further, the physical connection 126 is connected to the read-out circuit 130 to allow accumulated charges at the first charge transport layer 114 in the second lateral part 124 to be read out to the read-out circuit 130.

An insulating material may be used for providing insulation within the metal layer between the bias electrodes 110 and the physical connections 126. Further, a dielectric material layer (which may be different from the insulating material between the bias electrodes 110 and the physical connections 126) may be formed on the metal layer. This dielectric material layer will provide the dielectric material 112 that separates the bias electrode 110 from the stack 102. The dielectric material layer may be patterned to provide access through the dielectric material layer to the physical connection 126 to the read-out circuit 130. Then, the layers of the stack 102 may be formed on the semiconductor substrate 108, wherein the first charge transport layer 114 may extend through the dielectric material layer such that the first charge transport layer 114 is physically connected to the physical connection 126.

Referring now to Fig. 3, the photo-sensitive device 100 may be used in an array 202. The array 202 may thus enable detection of a plurality of signals representative of incident light on respective photo-sensitive devices 100 in the array 202. This may for instance be used for acquiring a spatially and/or spectrally resolved image. The array 202 of photo-sensitive devices 100 may thus for instance be used in an image sensor 200.

Fig. 3 shows a top view of the photo-sensitive device 100. For clarity, Fig. 3 shows the bias electrodes 110 and physical connections 126. Further, dashed lines are used for indicating different photo-sensitive devices 100 in the array 202.

The photon-absorbing layer 116 and the second charge transport layer 118 may be arranged as continuous layers extending over a plurality of photo-sensitive devices 100 of the array 202, such as extending over the entire array 202. The first charge transport layer 114 may also be arranged as a continuous layer extending over a plurality of photo-sensitive devices 100 of the array 202, such as extending over the entire array 202.

The photo-sensitive devices 100 in the array 202 may thus be defined by the bias electrodes 110 of neighboring photo-sensitive devices 100 being separated by an insulating material.

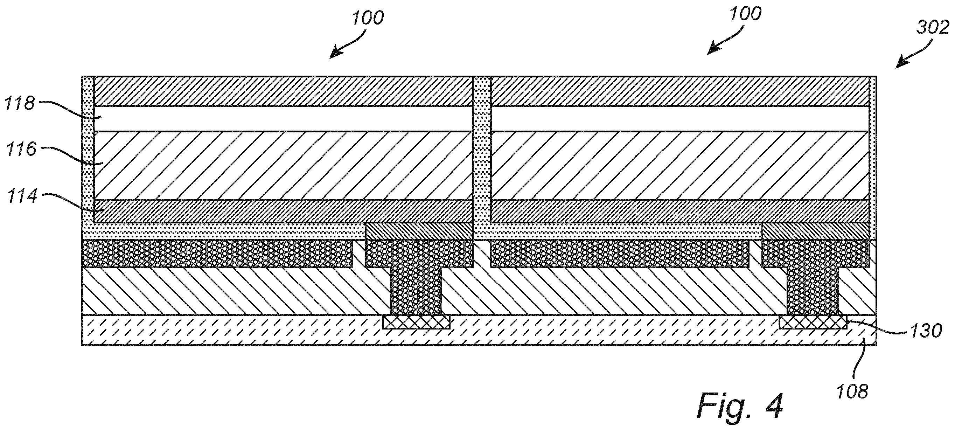

Referring now to Fig. 4, a cross-section of two photo-sensitive devices 100 of an array 302 is shown. Fig. 4 illustrates an alternative embodiment to the array 202 shown in Fig. 3. In the array 302 of photo-sensitive devices 100, the first charge transport layer 114, the photon-absorbing layer 116 and the second charge transport layer 118 are isolated between neighboring photo-sensitive devices 100 such that cross-talk between neighboring photo-sensitive devices 100 may be avoided or reduced.

The isolation of the neighboring photo-sensitive devices 100 may be formed after the first charge transport layer 114, the photon-absorbing layer 116 and the second charge transport layer 118 by forming trenches through the layers 114, 116, 118 and filling the trenches with an insulating material preventing charges to travel across the trenches.

The isolation of the neighboring photo-sensitive devices 100 may be achieved by the first charge transport layer 114 being isolated between neighboring photo-sensitive devices 100 while the photon-absorbing layer 116 and the second charge transport layer 118 may extend continuously over neighboring photo-sensitive devices 100. This may prevent transfer of charges in the first charge transport layer 114 between neighboring photo-sensitive devices 100. The first charge transport layer 114 may extend over the first lateral part 122 and the second lateral part 124 of each of the photo-sensitive devices 100.

It should be realized that isolations by trenches may be provided for each or some of the layers 114, 116, 118 between neighboring photo-sensitive devices 100. For instance, as will be explained below, the first charge transport layer 114 may be patterned to be arranged in relation to the second lateral part 124 of the photo-sensitive devices 100 such that no further isolation of the first charge transport layer 114 may be needed.

As mentioned above, the first charge transport layer 114, the photon-absorbing layer 116 and the second charge transport layer 118 of the photo-sensitive devices 100 may be arranged on the semiconductor substrate 108 comprising the read-out circuit 130 for reading out the signals representative of the incident light on the respective photo-sensitive devices 100. This implies that the array 202 or the array 302 of the photo-sensitive devices 100 with read-out circuit 130 may be very compact and allows forming an image sensor in a small-scale device.

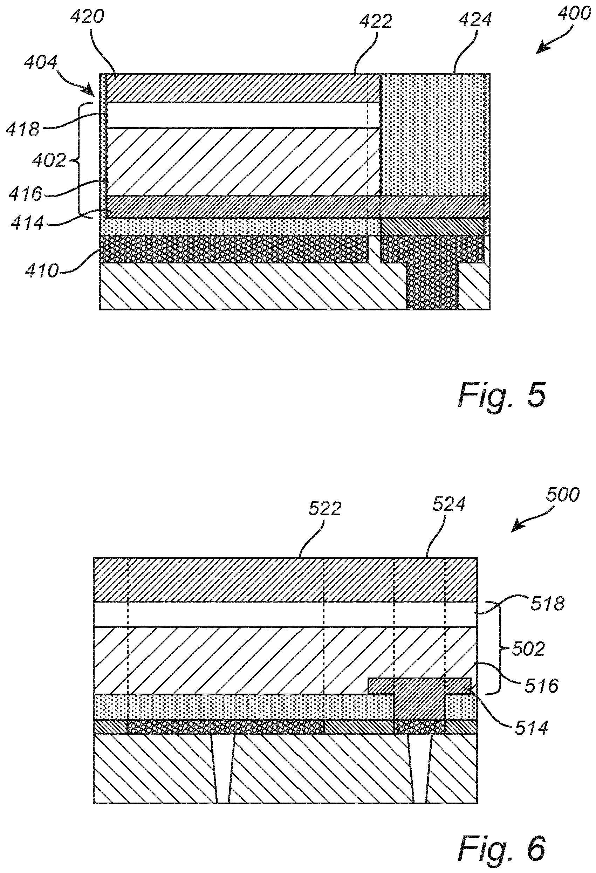

Referring now to Fig. 5, a cross-section of a photo-sensitive device 400 according to an alternative embodiment is shown.

As shown in Fig. 5, the photo-sensitive device 400 only comprises the first charge transport layer 414 of the stack 402 in the second lateral part 424 of the photo-sensitive device 400.

This implies that the photon-absorbing layer 416 and the second charge transport layer 418 do not extend to the second lateral part 424 of the photo-sensitive device 400.

In the first lateral part 422, the photo-sensitive device 400 comprises the first charge transport layer 414, the photon-absorbing layer 416 and the second charge transport layer 418.

In the photo-sensitive device 400, the first charge transport layer 414 is separated from the photon-absorbing layer 416 in the second lateral part 424 since the photon-absorbing layer 416 is not present in the second lateral part 424.

This implies that an effect of the accumulation of charges and varying of the potential at the first charge transport layer 414 in the second lateral part 424 on the voltage bias of the photodiode 404 as controlled by the potentials of the bias electrode 410 and the top electrode 420 is reduced.

Referring now to Fig. 6, a cross-section of a photo-sensitive device 500 according to yet an alternative embodiment is shown.

As shown in Fig. 6, the first charge transport layer 514 may be patterned such that the first charge transport layer 514 is arranged in the second lateral part 524 of the photo-sensitive device 500 and is absent at the first lateral part 522 of the photo-sensitive device 500.

The photo-sensitive device 500 comprises the first charge transport layer 514, the photon-absorbing layer 516 and the second charge transport layer 518 in the second lateral part 524 of the photo-sensitive device 500.

In the first lateral part 522, the photo-sensitive device 500 comprises only the photon-absorbing layer 516 and the second charge transport layer 518 of the stack 502. Thus, the bias electrode 510 is separated by the dielectric material 512 from the photon-absorbing layer 516.

It may even be contemplated that the embodiments of Figs 5-6 be mixed such that the photo-sensitive device would in the first lateral part comprise the photon-absorbing layer and the second charge transport layer of the stack and the photo-sensitive device would in the second lateral part comprise the first charge transport layer. Then, the photodiode would be defined diagonally through the photo-sensitive device.

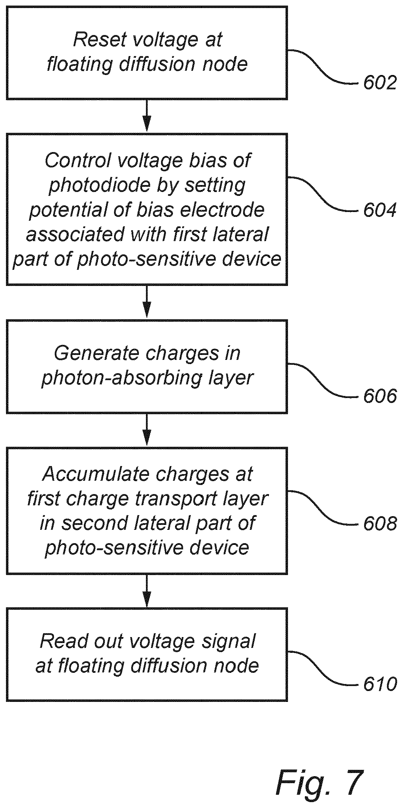

Referring now to Fig. 7, a method for light detection will be described. The method may be performed in any of the photo-sensitive devices described above, wherein the photo-sensitive device comprises a stack forming a photodiode, which stack comprises a first charge transport layer, a photon-absorbing layer and a second charge transport layer, and wherein the photo-sensitive device comprises a first lateral part and a second lateral part different from the first lateral part.

The method may comprise prior to the integration time, resetting 602 a voltage at the floating diffusion node which is formed at the first charge transport layer in the second lateral part of the photo-sensitive device.

The method further comprises controlling 604 a voltage bias of the photodiode by setting a potential of a bias electrode associated with and separated by a dielectric material from the stack at the first lateral part of the photo-sensitive device. The potential of the bias electrode is fixed during the integration time to provide a constant bias by the bias electrode during the integration time.

In fact, the potential of the bias electrode may be maintained constant not only during the integration time but throughout operation of the photodiode. Resetting of the floating diffusion node may ensure that signals read out from the photo-sensitive device relate to light incident on the photo-sensitive device during the integration time. However, the potential of the bias electrode may preferably be different between integration times, such that no reverse bias of the photodiode is provided between integration times and charges are not transported towards the floating diffusion node between integration times.

The potential of the bias electrode may be set in relation to the potential of the first charge transport layer at the second lateral part of the photo-sensitive device and to a top electrode, wherein the bias electrode and the top electrode are arranged at opposite sides of the stack. The potential of the bias electrode may be set such that charges to be accumulated in the first charge transport layer at the second lateral part of the photo-sensitive device are transported towards the first charge transport layer at the second lateral part of the photo-sensitive device during the integration time.

The method further comprises generating 606 charges during the integration time in the photon-absorbing layer in response to incident light on the photo-sensitive device.

The method further comprises accumulating 608 charges during the integration time at the first charge transport layer in the second lateral part of the photo-sensitive device.

The first charge transport layer in the second lateral part of the photo-sensitive device is connected to a read-out circuit and may define a floating diffusion node. The method may further comprise, at end of integration time, selectively reading out 610 a voltage signal at the floating diffusion node using the read-out circuit, wherein the voltage signal is representative of the incident light during the integration time on the photo-sensitive device.

Since charges are accumulated at the first charge transport layer in the second lateral part of the photo-sensitive device and the voltage bias of the photodiode is controlled by the bias electrode in the first lateral part, variations in light sensitivity of the photodiode due to variation in potential of the floating diffusion node may be avoided during integration time.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for light detection in a photo-sensitive device (100; 400; 500), wherein the photo-sensitive device (100; 400; 500) comprises a stack (102; 402; 502) forming a photodiode, which stack (102; 402; 502) comprises a first charge transport layer (114; 414; 514), a photon-absorbing layer (116; 416; 516) and a second charge transport layer (118; 418; 518), wherein the photon-absorbing layer (116; 416; 516) is arranged between the first charge transport layer (114; 414; 514) and the second charge transport layer (118; 418; 518), and wherein the first charge transport layer (114; 414; 514) and the second charge transport layer (118; 418; 518) are configured to transport charges of opposite signs, wherein the photo-sensitive device (100; 400; 500) comprises a first lateral part (122; 422; 522) and a second lateral part (124; 424; 524) different from the first lateral part (122; 422; 522), wherein the photo-sensitive device (100; 400; 500) in the first lateral part (122; 422; 522) comprises at least the photon-absorbing layer (116; 416; 516) and the second charge transport layer (118; 418; 518) of the stack (102; 402; 502) and wherein the photo-sensitive device (100; 400; 500) in the second lateral part (124; 424; 524) comprises at least the first charge transport layer (114; 414; 514) of the stack (102; 402; 502) , said method comprising:
controlling (604) a voltage bias of the photodiode by setting a potential of a bias electrode (110; 410; 510) associated with and separated by a dielectric material (112) from the stack (102; 402; 502) at the first lateral part (122; 422; 522) of the photo-sensitive device (100; 400; 500), wherein the potential of the bias electrode (110; 410; 510) is fixed during an integration time for controlling light sensitivity of the photodiode;
generating (606) charges during the integration time in the photon-absorbing layer (118; 418; 518) in response to incident light on the photo-sensitive device (100; 400; 500); and
accumulating (608) charges during the integration time at the first charge transport layer (114; 414; 514) in the second lateral part (124; 424; 524) of the photo-sensitive device (100; 400; 500), wherein the first charge transport layer (114; 414; 514) in the second lateral part (124; 424; 524) of the photo-sensitive device (100; 400; 500) is connected to a read-out circuit (130) for reading out a signal representative of the incident light during the integration time on the photo-sensitive device (100; 400; 500).

2. The method according to claim 1, wherein the potential of the bias electrode (110; 410; 510) is set in relation to potential of the first charge transport layer (114; 414; 514) at the second lateral part (124; 424; 524) of the photo-sensitive device (100; 400; 500) such that charges to be accumulated in the first charge transport layer (114; 414; 514) at the second lateral part (124; 424; 524) of the photo-sensitive device (100; 400; 500) are transported towards the first charge transport layer (114; 414; 514) at the second lateral part (124; 424; 524) of the photo-sensitive device (100; 400; 500) during the integration time.

3. The method according to claim 1 or 2, wherein the first lateral part (122; 422; 522) of the photo-sensitive device (100; 400; 500) defines a first area corresponding to a projection of the stack (102; 402; 502) onto the bias electrode (110; 410; 510) and wherein the second lateral part (124; 424; 524) of the photo-sensitive device (100; 400; 500) defines a second area corresponding to a cross-section of an interconnect (126) between the first charge transport layer (114; 414; 514) and the read-out circuit (130), wherein the first area is larger than the second area.

4. The method according to any one of the preceding claims, wherein the first charge transport layer (114; 414) is separated from the photon-absorbing layer (116; 416) at the second lateral part (124; 424) of the photo-sensitive device (100; 400).

5. The method according to any one of the preceding claims, wherein the photo-sensitive device (100; 400; 500) further comprises a top electrode (120; 420) arranged at an opposite side of the stack (100; 400; 500) in relation to the bias electrode (110; 410; 510), wherein the method further comprises setting a potential of the top electrode (120; 420) in relation to the potential of the bias electrode (110; 410; 510) such that charges to be accumulated in the first charge transport layer (114; 414; 514) at the second lateral part (124; 424; 524) of the photo-sensitive device (100; 400; 500) are transported in the photon-absorbing layer (116; 416; 516) towards the first charge transport layer (114; 414; 514) during the integration time.

6. The method according to any one of the preceding claims, wherein the first charge transport layer (114; 414; 514) at the second lateral part (124; 424; 524) of the photo-sensitive device (100; 400; 500) defines a floating diffusion node, the method further comprising, at end of the integration time, selectively reading out (610) a voltage signal at the floating diffusion node using the read-out circuit (130).

7. The method according to claim 6, further comprising, prior to the integration time, resetting (602) a voltage at the floating diffusion node using the read-out circuit (130).

8. A photo-sensitive device (100; 400; 500) comprising:
a stack (102; 402; 502) forming a photodiode, which stack (120; 402; 502) comprises a first charge transport layer (114; 414; 514), a photon-absorbing layer (116; 416; 516) and a second charge transport layer (118; 418; 518), wherein the photon-absorbing layer (116; 416; 516) is arranged between the first charge transport layer (114; 414; 514) and the second charge transport layer (118; 418; 518), and wherein the first charge transport layer (114; 414; 514) and the second charge transport layer (118; 418; 518) are configured to transport charges of opposite signs, and wherein the photon-absorbing layer (116; 416; 516) is configured to generate charges in response to incident light on the photo-sensitive device (100; 400; 500), wherein the photo-sensitive device (100; 400; 500) comprises a first lateral part (122; 422; 522) and a second lateral part (124; 424; 524) different from the first lateral part (122; 422; 522), wherein the photo-sensitive device (100; 400; 500) in the first lateral part (122; 422; 522) comprises at least the photon-absorbing layer (116; 416; 516) and the second charge transport layer (118; 418; 518) of the stack (102; 402; 502) and wherein the photo-sensitive device (100; 400; 500) in the second lateral part (124; 424; 524) comprises at least the first charge transport layer (114; 414; 514) of the stack (102; 402; 502);
a bias electrode (110; 410; 510) associated with and separated by a dielectric material (112) from the stack (102; 402; 502) at the first lateral part (122; 422; 522) of the photo-sensitive device (100; 400; 500), wherein the photo-sensitive device (100; 400; 500) is configured to set a fixed potential of the bias electrode (110; 410; 510) during an integration time for controlling light sensitivity of the photodiode;
wherein the photo-sensitive device (100; 400; 500) is configured to accumulate charges at the first charge transport layer (114; 414; 514) in the second lateral part (124; 424; 524) of the photo-sensitive device (100; 400; 500) during the integration time, and wherein the first charge transport layer (114; 414; 514) in the second lateral part (124; 424; 524) of the photo-sensitive device (100; 400; 500) is connected to a read-out circuit (130) for reading out a signal representative of the incident light during the integration time on the photo-sensitive device (100; 400; 500).

9. The photo-sensitive device according to claim 8, wherein the first charge transport layer (114; 414) is separated from the photon-absorbing layer (116; 416) at the second lateral part (124; 424) of the photo-sensitive device (100; 400).

10. The photo-sensitive device according to claim 8 or 9, wherein the first charge transport layer (114; 414; 514) is an electron transport layer and the second charge transport layer (118; 418; 518) is a hole transport layer.

11. The photo-sensitive device according to any one of claims 8-10, wherein the first lateral part (122; 422; 522) of the photo-sensitive device (100; 400; 500) defines a first area corresponding to a projection of the stack (102; 402; 502) onto the bias electrode (110; 410; 510) and wherein the second lateral part (124; 424; 524) of the photo-sensitive device (100; 400; 500) defines a second area corresponding to a cross-section of an interconnect (126) between the first charge transport layer (114; 414; 514) and the read-out circuit (130), wherein the first area is larger than the second area.

12. An image sensor (200) comprising an array (202; 302) of photo-sensitive devices (100) according to any one of claims 8-11.

13. The image sensor according to claim 12, wherein the second charge transport layer (118; 518) and the photon-absorbing layer (116; 516) are continuous layers extending over a plurality of photo-sensitive devices (100) of the array (202; 302).

14. The image sensor according to claim 12 or 13, wherein the first charge transport layer (114; 414; 514), the photon-absorbing layer (116; 416; 516) and the second charge transport layer (118; 418; 518) of the photo-sensitive devices (100; 400; 500) are arranged on a semiconductor substrate (108) comprising the read-out circuit (130) for reading out the signals representative of the incident light on the photo-sensitive device (100; 400; 500).
